# EUROPÄISCHE PATENTSCHRIFT

(11) **EP 0 459 001 B1**
(45) Veröffentlichungstag und Bekanntmachung des Hinweises auf die Patenterteilung: **24.01.1996**
(21) Anmeldenummer: 90110393.7
(22) Anmeldetag: 31.05.1990
(51) Int. Cl.: G11C 29/00

(54) **Integrierter Halbleiterspeicher**
Integrated semiconductor memory
Mémoire intégrée à semi-conducteur

(43) Veröffentlichungstag der Anmeldung: 04.12.1991
(73) Patentinhaber: SIEMENS AKTIENGESELLSCHAFT, D-80333 München (DE)
(72) Erfinder: Muhmenthaler, Peter, Dipl.-Ing., D-8000 München 83 (DE); Oberle, Hans Dieter, Dipl.-Ing., D-8039 Puchheim (DE)

(56) Entgegenhaltungen:
- EP-A- 0 310 111
- PROCEEDINGS OF THE INTERNATIONAL TEST CONFERENCE 1989, 29. - 31. August 1989, Seiten 819-828, IEEE, New York, US; A. SAMAD et al.: "Automatic ASIC design-for-testability-the VLSI test assistant"
- ELEKTRONIK, Band 39, Nr. 7, 30. März 1990, Seiten 38-47, München, DE; H.C. RITTER et al.: "Selbsttest von Prozessor-Chips"

## Beschreibung

Die Erfindung betrifft einen integrierten Halbleiterspeicher gemäß dem Oberbegriff des Anspruchs 1.

In der Zeitschrift Mikroelektronik, Band 4 (1990), Heft 1, Seiten 12-31 sind Blockschaltbilder verschiedener Halbleiterspeicher typen gezeigt (S. 13/15: Video RAMS, S. 18/20: SRAM S. 28/: DRAM: Der Halbleiterspeicher ist, wie hier zu sehen, in mehrere Funktionsblöcke wie Zellenfelder, Bit-Wortleitungs-Decoder, Taktgeneratoren usw. aufgeteilt. Jeder dieser Funkionsblöcke kann nochmals in kleinere Einheiten unterteilt sein. In Halbleiterspeichern hoher Integrationsdichte sind zudem meist Testeinheiten vorgesehen, die ein effektives und schnelles Testen der Speicherzellen ermöglichen sollen.

Im Zuge höherer Integration der Halbleiterspeicher nimmt nicht nur die Speicherkapazität, sondern auch die Anzahl und Komplexität der peripheren Funktionseinheiten zu. So kann beispielsweise zwischen verschiedenen Organisationsformen und Betriebsarten des Halbleiterspeichers gewählt werden. Für jede neue Betriebsart muß unter Umständen der gesamte Speicher, d.h. alle Speicherzellen getestet werden. In der Europäischen Patentschrift EP-A2-0 310 111 wird ein Vorgehen zum Testen der Funktionseinheiten eines Halbleiterspeichers beschreiben.Ein gezieltes Testen einer einzelnen Funktionseinheit ist im derzeitigen Halbleiterspeicher unmöglich. Arbeitet eine einzelne Funktionseinheit nicht einwandfrei oder ist sie völlig defekt, müssen über einen Test der Speicherzellen Rückschlüsse z.B. durch eine geeignete Interpretation auf die defekte Funktionseinheit gezogen werden. Oft ist dies nur schwer möglich oder führt zu einem falschen Schluß. Auch in der Entwicklungsphase eines Halbleiterspeichers wäre es von großem Vorteil, einzelne Funktionseinheiten gezielt zu testen, um die Entwicklungszeiten zu verkürzen. Letztlich kann in erheblichem Maße die Test- und Analysezeit eines Halbleiterspeichers verkürzt werden, wenn erst die wichtigsten Funktionseinheiten des Halbleiterspeichers getestet werden und dann in meist einfacheren Tests das Zusammenspiel der Funktionseinheiten geprüft wird.

Aufgabe der Erfindung ist es, einen integrierten Halbleiterspeicher zu schaffen, der es ermöglicht, einzelne Funktionseinheiten des Halbleiterspeichers gezielt zu testen.

Die Aufgabe wird gelöst durch die kennzeichnendnen Merkmale des Anspruchs 1.
Weiterbildungen sind Gegenstand der Unteransprüche.

Die Erfindung wird nachfolgend anhand von drei Figuren näher erläutert. Es zeigen:
- Figur 1: einen Ausschnitt eines erfindungsgemäßen Halbleiterspeichers und
- Figur 2: einen weiteren Ausschnitt eines erfindungsgemäßen Halbleiterspeichers mit einem Multiplexer in Stellung Speicherbetrieb.
- Figur 3: den Multiplexer aus Figur 2 in Stellung Testbetrieb.

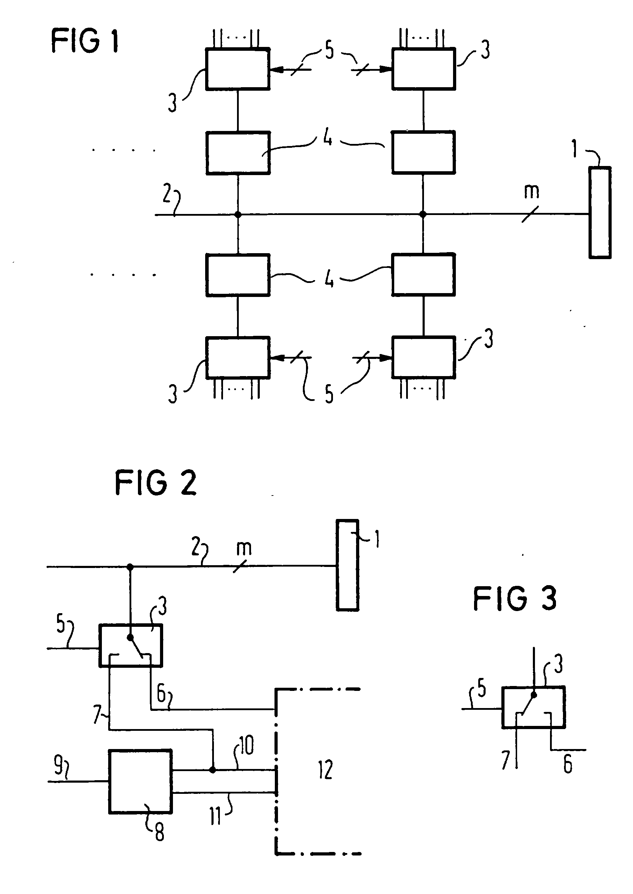

In dem in Figur 1 gezeigten Ausschnitt wurde auf die für die Erfindung unwesentlichen Bereiche des Halbleiterspeichers aus Gründen der Übersichtlichkeit verzichtet. So stellt der Block 1 in der Figur 1 schematisch den Bereich der Anschlußklemmen dar. Diese Anschlüsse 1 sind mit einem aus m Leitungen bestehenden Bus 2 verbunden. Der erfindungsgemäße Halbleiterspeicher weist zusätzlich einen Multiplexer 3 auf. Der Bus 2 ist jeweils mit dem Ausgang mehrerer Multiplexer 3 verbunden. Derartige Multiplexer sind aus Tietze Schenk 8te Aufl. (1986), Seite 224 bekannt und können je nach zu schaltendem Signal uni- oder bidirektionale Signalübertragung gewährleisten. Dies kann, wie in der Figur 1 dargestellt, z.B. über Treiberstufen 4 erfolgen. Die Multiplexer 3 werden über Steuereingänge 5 von einer nicht dargestellten Testeinheit gesteuert. Die Eingänge der Multiplexer 3 sind zum einen mit den für den Speicherbetrieb notwendigen Signalleitungen sowie mit den für diverse Testbetriebsarten notwendigen internen Knotenpunkten der internen Signalleitungen des Halbleiterspeichers verbunden.

In der Speicherbetriebsart verbinden die Multiplexer 3 die für den Speicherbetrieb notwendigen Signalleitungen mit dem Bus 2. Dieser Bus 2 führt die für den Speicherbetrieb notwendigen Signale zu den Anschlüssen 1. Der Halbleiterspeicher verhält sich nun wie ein herkömmlicher Speicherbaustein. Ein Umschalten des Halbleiterspeichers in die Testbetriebsart geschieht vorzugsweise gemäß dem JEDEC-Standard mit einem "Write-enable and CAS before RAS-Zyklus". Das Umschalten in die Testbetriebsart könnte aber auch dadurch erreicht werden, daß ein bestimmter Signalpegel an ein zusätzliches Pad angelegt wird. Die Testeinheit erkennt diesen Signalpegel und schaltet den Halbleiterspeicher in die Testbetriebsart um. Während dieses Umschaltzyklus erkennt die Testeinheit ein an k Adreßanschlüssen anliegendes Codewort, welches der Testeinheit signalisiert, den Halbleiterspeicher in eine bestimmte Testbetriebsart umzuschalten. Uber weitere e Adreßeingänge des Halbleiterspeichers kann ein zusätzliches Codewort angelegt werden, welches das zu testende Funktionsmodul auswählt. Bei einem 16M-Speicher wird z.B. das Codewort für die Testbetriebsart an den Adreßpinns A0 bis A7 angelegt. Durch das an den Adreßpinns A8 bis All anliegend weitere Codewort können nun maximal 16 verschiedene Funktionseinheiten selektiert werden. Sollte die zu prüfende Funktionseinheit mehr Signale erzeugen als Datenanschlüsse vorhanden sind, so ist eine Unterteilung in Subfunktionseinheiten notwendig. Dies kann z.B. über ein drittes Codewort, welches beim Umschalten in die Testbetriebsart an die Dateneingänge des Halbleiterspeichers angelegt wird, erfolgen. Nach dem UmschaLtzyklus verhält sich der Halbleiterspeicher wie in der Speicherbetriebsart, mit dem Unterschied, daß die zu testenden Ein- bzw. Ausgangssignale einer Funktionseinheit z.B. an den Datenleitungen des Halbleiterspeichers anliegen. Auf diese Weise wird die Steuerbarkeit und Beobachtbarkeit interner Zustände umfassend sichergestellt. Die Rückkehr in den Normalbetrieb bedarf eines speziellen Zyklus entsprechend dem Umschalten in die Testbetriebsart. Hierfür ist allerdings nur ein erstes spezielles Codewort, das an die Adreßpins A0 bis A7 angelegt wird, notwendig. Alternativ könnte aber auch eine automatische Rückkehr in den Normalbetrieb implementiert werden. Dies könnte z.B. nach einer vorgegebenen maximalen Anzahl von Betriebszyklen gewährleistet werden.

In Figur 2 und Figur 3 wird das Umschalten in die Testbetriebsart zum Testen einer einfachen Funktionseinheit gezeigt. Der in Figur 2 dargestellte Ausschnitt eines Halbleiterspeichers weist wiederum einen Bus 2 mit m Leitungen auf, der zum einen mit den Anschlüssen 1 des Halbleiterspeichers und zum anderen mit dem Ausgang eines Multiplexers 3 verbunden ist. Der Multiplexer wird durch eine Steuerleitung 5 gesteuert und weist zwei Eingänge auf, die mit Signalleitungen 6 und 7 verbunden sind. Die zu testende Funktionseinheit ist hier mit 8 bezeichnet. Sie weist eine Eingangsleitung 9 und zwei Ausgangsleitungen 10, 11 auf. Die Ausgangsleitungen 10, 11 führen zu einem Block 12, der symbolisch für weitere Funktionseinheiten des Halbleiterspeichers steht. Die zum Multiplexer führende Eingangsleitung 6 wird durch ein Ausgangssignal aus dem Block 12 gespeist. Die zweite Eingangsleitung 7 des Multiplexers ist mit der Ausgangsleitung 10 verbunden.

Im Speicherbetrieb verbindet der Multiplexer 3 wie in Figur 2 dargestellt die Signalleitung 6 mit dem Bus 2. Die Funktionseinheit 8, z.B. ein Taktgenerator, wird durch das an der Eingangsleitung 9 anliegende Signal gesteuert und erzeugt z.B. zwei Ausgangssignale, die über die Leitungen 10, 11 weiteren im Block 12 enthaltenen Funktionseinheiten zugeführt werden. Diese weiteren Funktionseinheiten im Block 12 erzeugen nun ein Ausgangssignal, z.B. ein den Dateninhalt einer Speicherzelle repräsentierendes Datensignal, welches über die Datenleitung 6, den Multiplexer 3 und den Bus 2 einer den Block 1 enthaltenden Anschlußklemme zugeführt wird.

Es sei nun angenommen, daß zum Testen der Funktionseinheit 8 das Ausgangssignal 10 von besonderem Interesse ist. Die in Figur 2 gezeigte Schaltung ermöglicht es nun, diese Signalleitung über den Multiplexer 3 und den Bus 2 mit einer den Block 1 enthaltenden Anschlußklemme zu verbinden. Über die Steuerleitung 5 wird der Multiplexer 3 derart gesteuert, daß er die Signalleitung 7 mit dem Bus 2 verbindet. Dieser Zustand des Multiplexers 3 ist in Figur 3 dargestellt. Die Signalleitung 6 ist nun vom Bus abgekoppelt. Die Umschaltung des Multiplexers geschieht innerhalb des Testmode-Aktivierungszyklus. Während der nächsten Zyklen des Halbleiterspeichers kann der Halbleiterspeicher wie im Speicherbetrieb angesteuert werden. Der Halbleiterspeicher arbeitet nun auch weiterhin wie im Speicherbetrieb mit dem Unterschied, daß an einer den Block 1 enthaltenden Anschlußklemme nicht das im Normalbetrieb erzeugte Datensignal, sondern das Ausgangssignal der Funktionseinheit 8 anliegt. Dieses Ausgangssignal kann nun vom Tester während normal ablaufender Speicherfunktionen beobachtet werden.

Die erfindungsgemäße Testschaltung ist bei allen Speichertypen (z. B. SRAM, DRAM, Video RAM usw.) anwendbar.

## Patentansprüche

1. Halbleiterspeicher, der in mehrere Funktionseinheiten (8) aufgeteilt ist, mit von außen zugänglichen m Anschlüssen (1), mit internen Signalleitungen (6), die von den Funktionseinheiten zu den Anschlüssen führen, und internen Signalleitungen (10, 11), die die Funktionseinheiten miteinander verbinden, mit einer Testeinheit, die einen Testbetrieb durch ein an K Anschlüssen anliegendes Codewort erkennt, wobei K ≤ m, mit Mittel (5) zum Umschalten vom Speicherbetrieb in den Testbetrieb
**dadurch gekennzeichnet**, daß die Testeinheit mindestens eine (6) der zu den Anschlüssen führenden Signalleitungen vom zugehörigen Anschluß des Halbleiterspeichers abkoppelt und diesen Anschluß mit einer die Funktionseinheiten verbindenden internen Signalleitung (10) verbindet.

2. Halbleiterspeicher nach Anspruch 1,
**dadurch gekennzeichnet**,
daß der Halbleiterspeicher einen Datenbus (2) enthält, dessen Datenbusleitungen mit den Anschlüssen verbunden sind, daß mindestens ein Multiplexer (3), mit 1 Ausgang und mindestens 2 Eingängen, vorgesehen ist, dessen Ausgang mit einer Datenbusleitung verbunden ist, dessem ersten Eingang das im Speicherbetrieb für die zugehörige Datenbusleitung notwendige interne Signal zugeführt wird und dessen weitere Eingänge mit jeweils einer die Funktionseinheiten verbindenden Signalleitung verbunden sind.

3. Halbleiterspeicher nach einem der vorhergehenden Ansprüche,
**dadurch gekennzeichnet**,
daß die zum Testen einer Funktionseinheit notwendigen Signale von der Testeinheit erzeugt werden.

4. Halbleiterspeicher nach einem der Ansprüche 1 bis 3,
**dadurch gekennzeichnet**,
daß der Halbleiterspeicher zusätzlich zu den üblichen Anschlußpads ein weiteres Anschlußpad aufweist und daß das Umschalten vom Speicherbetrieb in den Testbetrieb durch ein dem zusätzlichen Anschlußpad zugeführtes Signal erfolgt.

5. Halbleiterspeicher nach einem der Ansprüche 1 bis 4,
**dadurch gekennzeichnet**,
daß das Ende des Testbe'triebs durch ein zweites an K (K m) Anschlüssen anliegendes Codewort erfolgt.

6. Halbleiterspeicher nach einem der Ansprüche 1 bis 5,
**dadurch gekennzeichnet**,
daß das Ende des Testbetriebs und der Übergang in den Speicherbetrieb nach einer vorgegebenen Anzahl von Zyklen erfolgt.

7. Halbleiterspeicher nach einem der Ansprüche 1 bis 6,
**dadurch gekennzeichnet**,
daß während das erste Codewort an den Anschlüssen anliegt, durch ein weiteres an n (n+K≤m) Anschlüssen anliegendes Codewort eine von 2ⁿ testbaren Funktionseinheiten ausgewählt wird.

8. Halbleiterspeicher nach einem der vorherigen Ansprüche,
**dadurch gekennzeichnet**, daß das Umschalten innerhalb eines einzigen Zyklus bezogen auf den Speicherbetrieb erfolgt.

9. Halbleiterspeicher nach einem der Ansprüche 1 bis 6,
**dadurch gekennzeichnet**, daß nachdem in einen ersten Zyklus mit einem ersten Codewort der Testbetrieb eingeschaltet wurde, in weiteren Zyklen mit weiteren Codewörtern verschiedene Funktions- und Testeinheiten ausgewählt werden.

## Claims

1. Semiconductor memory which is divided into a plurality of functional units (8), having m externally accessible connections (1), having internal signal lines (6) which lead from the functional units to the connections and having internal signal lines (10, 11) which connect the functional units to one another, having a test unit which identifies a test mode from a code word applied to K connections, where K ≤ m, having means (5) for changing over from the memory mode to the test mode, characterized in that the test unit decouples at least one (6) of the signal lines leading to the connections from the associated connection of the semiconductor memory and connects this connection to an internal signal line (10) which connects the functional units.

2. Semiconductor memory according to Claim 1, characterized in that the semiconductor memory contains a data bus (2), the data bus lines of which are connected to the connections, in that at least one multiplexer (3) having 1 output and at least 2 inputs is provided, the output of which is connected to a data bus line, the first input of which is fed the internal signal which is necessary for the associated data bus line in the memory mode, and the further inputs of which are each connected to a signal line which connects the functional units.

3. Semiconductor memory according to one of the preceding claims, characterized in that the signals which are necessary for testing a functional unit are generated by the test unit.

4. Semiconductor memory according to one of Claims 1 to 3, characterized in that the semiconductor memory has a further connection pad in addition to the normal connection pads, and in that the changeover from the memory mode to the test mode is effected as a result of a signal which is fed to the additional connection pad.

5. Semiconductor memory according to one of Claims 1 to 4, characterized in that the end of the test mode is effected as a result of a second code word applied to K (K ≤ m) connections.

6. Semiconductor memory according to one of Claims 1 to 5, characterized in that the end of the test mode and the transition to the memory mode are effected after a predetermined number of cycles.

7. Semiconductor memory according to one of Claims 1 to 6, characterized in that while the first code word is present at the connections, one of 2ⁿ testable functional units is selected as a result of a further code word applied to n (n+K≤m) connections.

8. Semiconductor memory according to one of the preceding claims, characterized in that the changeover is effected within a single cycle with reference to the memory mode.

9. Semiconductor memory according to one of Claims 1 to 6, characterized in that, after the test mode has been switched on in a first cycle using a first code word, various functional and test units are selected in further cycles using further code words.

## Revendications

1. Mémoire à semi-conducteur, qui est divisée en plusieurs unités fonctionnelles (8), qui comporte m raccordements (1) accessibles de l'extérieur, des conducteurs (6) internes de signaux, qui mènent des unités fonctionnelles aux raccordements, des conducteurs (10, 11) internes de signaux, qui relient l'une à l'autre les unités fonctionnelles, une unité de test, qui reconnaît un fonctionnement de test par l'application d'un mot de code à K raccordements, K ≤ m, des moyens (5) de commutation du fonctionnement de mémorisation dans le fonctionnement de test,
caractérisée en ce que l'unité de test coupe du raccordement associé de la mémoire à semi-conducteur au moins l'un (6) des conducteurs de signaux menant aux raccordements et relie ce raccordement à un conducteur (10) de signaux interne et reliant les unités fonctionnelles.

2. Mémoire à semi-conducteur suivant la revendication 1, caractérisée en ce que la mémoire à semi-conducteur comprend un bus (2) de données, dont les conducteurs de bus de données sont reliés aux raccordements, au moins un multiplexeur (3), qui comporte une sortie et au moins deux entrées, dont la sortie est reliée à un conducteur du bus de données, à la première entrée duquel le signal interne nécessaire en fonctionnement de mémorisation au conducteur associé du bus de données est envoyé et dont les autres entrées sont reliées chacune à un conducteur de signaux reliant les unités fonctionnelles, est prévu.

3. Mémoire à semi-conducteur suivant l'une des revendications précédentes, caractérisée en ce que les signaux nécessaires aux tests d'une unité fonctionnelle sont produits par l'unité de test.

4. Mémoire à semi-conducteur suivant l'une des revendications 1 à 3, caractérisée en ce que la mémoire à semi-conducteur comporte en plus des plots habituels de raccordement un plot supplémentaire de raccordement et la commutation du fonctionnement de mémorisation dans le fonctionnement de test s'effectue par un signal envoyé au plot supplémentaire de raccordement.

5. Mémoire à semi-conducteur suivant l'une des revendications 1 à 4, caractérisée en ce que l'achèvement du fonctionnement de test s'effectue par l'application d'un second mot de code à K (K ≤ m) raccordements.

6. Mémoire à semi-conducteur suivant l'une des revendications 1 à 5, caractérisée en ce que l'achèvement du fonctionnement de test et le passage au fonctionnement de mémorisation s'effectue après un nombre prescrit de cycles.

7. Mémoire à semi-conducteur suivant l'une des revendications 1 à 6, caractérisée en ce que pendant que le premier mot de code est appliqué aux raccordements, l'une parmi 2ⁿ unités fonctionnelles pouvant être testées est choisie par l'application d'un autre mot de code à n (n + K ≤ m) raccordements.

8. Mémoire à semi-conducteur suivant l'une des revendications précédentes, caractérisée en ce que la commutation pendant un seul cycle s'effectue par rapport au fonctionnement de mémorisation.

9. Mémoire à semi-conducteur suivant l'une des revendications 1 à 6, caractérisée en ce qu'après le démarrage du fonctionnement de test pendant un premier cycle par un premier mot de code, des unités fonctionnelles et de test différentes sont sélectionnées pendant d'autres cycles par d'autres mots de code.
